# EUROPÄISCHE PATENTSCHRIFT

(11) **EP 3 631 980 B1**
(45) Veröffentlichungstag und Bekanntmachung des Hinweises auf die Patenterteilung: **13.07.2022**
(21) Anmeldenummer: 18728537.4
(22) Anmeldetag: 16.05.2018
(51) Int. Cl.: H03F 1/32, H03F 3/19, H03F 3/30, H03F 3/21, H03F 3/26, H01J 37/32, H01P 5/10

(54) **HOCHFREQUENZVERSTÄRKERANORDNUNG UND VERFAHREN ZUR AUSLEGUNG EINER HOCHFREQUENZVERSTÄRKERANORDNUNG**
HIGH FREQUENCY AMPLIFIER ARRANGEMENT AND METHOD FOR DESIGNING A HIGH FREQUENCY AMPLIFIER ARRANGEMENT
ENSEMBLE AMPLIFICATEUR À HAUTE FRÉQUENCE ET PROCÉDÉ POUR CONFIGURER UN ENSEMBLE AMPLIFICATEUR À HAUTE FRÉQUENCE

(30) Priorität: 26.05.2017 DE 102017208917
(43) Veröffentlichungstag der Anmeldung: 08.04.2020
(73) Patentinhaber: TRUMPF Hüttinger GmbH + Co. KG, 79111 Freiburg (DE)
(72) Erfinder: MAIER, Florian, 79292 Pfaffenweiler (DE); WERNER, Sergej, 52078 Aachen (DE)
(74) Vertreter: Kohler Schmid Möbus Patentanwälte
(86) Internationale Anmeldenummer: PCT/EP2018/062774
(87) Internationale Veröffentlichungsnummer: WO 2018/215263

(56) Entgegenhaltungen:
- EP-A2- 1 202 446
- WO-A1-2017/001602
- WO-A1-2017/001602
- WO-A2-02/31966
- WO-A2-02/31966
- US-A- 6 107 885
- US-A1- 2005 083 122
- US-A1- 2005 083 122
- US-A1- 2011 117 860

## Beschreibung

Die Erfindung betrifft eine Hochfrequenzverstärkeranordnung. Weiterhin betrifft die Erfindung ein Verfahren zur Auslegung einer Hochfrequenzverstärkeranordnung.

Die WO 2017/001602 A1 offenbart eine Hochfrequenzverstärkeranordnung, die geeignet ist, Ausgangsleistungen ≥ 1 kW bei Frequenzen ≥ 2 MHz zur Plasmaanregung zu erzeugen, umfassend
- zwei Transistoren, die mit ihrem Source-Anschluss jeweils mit einem Masseverbindungspunkt verbunden sind, wobei die Transistoren gleichartig ausgebildet sind und an einer mehrlagigen Leiterkarte angeordnet sind,
- einen Leistungsübertrager, dessen Primärwicklung mit den Drain-Anschlüssen der Transistoren verbunden ist, wobei die Primärwicklung und die Sekundärwicklung des Leistungsübertragers jeweils als planare Leiterbahnen ausgeführt sind, die in unterschiedlichen oberen Lagen der mehrlagigen Leiterkarte angeordnet sind.

Die US 6,107,885 und US2011/117860 offenbaren eine Anordnung gemäß dem Oberbegriff von Anspruch 1.

Beim Betrieb von Hochfrequenzgeneratoren entsteht häufig ein erhöhter Anteil harmonischer Komponenten im Ausgangssignal, also eine Reduktion der spektralen Reinheit. Dies kann insbesondere bei den hohen Anforderungen an Messgenauigkeit und Prozessstabilität von Plasmaprozessen höchst unerwünscht sein.

Aufgabe der vorliegenden Erfindung ist es, eine Hochfrequenzverstärkeranordnung bereitzustellen, bei der diese Nachteile nicht auftreten.

Gelöst wird diese Aufgabe erfindungsgemäß durch eine Hochfrequenzverstärkeranordnung mit den Merkmalen von Patentanspruch 1. Symmetrierübertrager (Engl. Balanced/Unbalanced, BalUn) werden häufig zur Wandlung zwischen einem symmetrischen Leitungssystem und einem unsymmetrischen Leitungssystem verwendet. Ein symmetrisches Leitungssystem ist beispielsweise das Leitungssystem an den Ausgangsanschlüssen des Verstärkerteils, weil sich hier beide Anschlüsse symmetrisch gegenüber einem Bezugspotential befinden, hier insbesondere gegenüber Masse. Ein unsymmetrisches Leitungssystem ist beispielsweise das Leitungssystem an den Ausgangsanschlüssen des Symmetrierübertragers, weil hier ein Anschluss mit einem festen Bezugspotential verbunden ist, hier insbesondere Masse, und der andere Anschluss eine Spannung aufweisen kann oder soll, die sich gegenüber diesem festen Bezugspotential ändert. Symmetrierübertrager können am Ausgang eines Verstärkerteils einer Hochfrequenzverstärkeranordnung eingesetzt werden. Es wurde erkannt, dass ein Symmetrierübertrager unsymmetrische parasitäre Komponenten aufweisen kann. Insbesondere kann er unsymmetrische parasitäre Kapazitäten aufweisen. Es wurde weiter erkannt, dass diese die Gleichtaktunterdrückung und somit die Qualität des Übertragers reduzieren. Es wurde weiter erkannt, dass beim Einsatz von solchen Symmetrierübertragern in Hochfrequenzgeneratoren dies für einen erhöhten Anteil harmonischer Komponenten im Ausgangssignal, also eine Reduktion der spektralen Reinheit, sorgt.

Es wurde erkannt, dass die parasitären Kapazitäten von Eingangsanschluss zu Ausgangsanschluss des Symmetrierübertragers sogar vom Wert gleich sein können, und trotzdem aufgrund unterschiedlicher Phasenbeziehungen der Eingangsanschlüsse zu den Ausgangsanschlüssen unterschiedliche Spannungsverhältnisse über diesen gleichen Kapazitätswerte herrschen. Dies führt zu einem unterschiedlichen Stromfluss über diese parasitären Kapazitäten. Damit erscheinen die Impedanzen an den Eingangsanschlüssen gegenüber Masse unterschiedlich, obwohl die parasitären Kapazitäten einzeln gemessen gleich sind. Um die Impedanzen anzugleichen, ist erfindungsgemäß vorgesehen, die Kapazitäten, die an den Symmetrierübertrager angeschlossen werden, unsymmetrisch zu gestalten, also die erste Kapazität ungleich der zweiten Kapazität auszulegen.

Mit Hilfe einer unsymmetrischen Bestückung, d.h. ungleichen Kapazitäten, lässt sich eine sehr breitbandige Kompensation der parasitären Komponenten erzielen und die Gleichtaktunterdrückung stark steigern. Beim Einsatz von Symmetrierübertragern im Ausgangsnetzwerk einer Hochfrequenzverstärkeranordnung werden somit an den Eingängen des Symmetrierübertragers Kapazitäten gegen Masse eingesetzt, um die Impedanzen der speisenden Elemente anzupassen. Diese Kapazitäten werden erfindungsgemäß entgegen dem allgemeinen Verständnis nicht mit gleichen sondern mit gezielt unterschiedlichen Werten ausgeführt. Die Impedanzen, die an den speisenden Elementen des Verstärkerteils sichtbar sind, werden durch diese Modifikation identisch. Dies ist sowohl für die harmonische Reinheit wie auch für weitere unerwünschte Effekte, wie Oszillationen, z.B. bei Fehlanpassung, und ungleiche Erwärmung der aktiven Bauteile von Vorteil.

Die erste Kapazität und die zweite Kapazität können sich in Abhängigkeit des Übertragungsverhältnisses des Symmetrierübertragers unterscheiden. Das Übertragungsverhältnis des Symmetrierübertragers kann somit berücksichtigt werden, um die Kapazitäten zu dimensionieren.

Der Symmetrierübertrager kann eine Primärwicklung aufweisen, die mit den zwei Eingangsanschlüssen verbunden ist, und eine Sekundärwicklung aufweisen, die mit den zwei Ausgangsanschlüssen verbunden ist. Durch den Symmetrierübertrager kann eine galvanische Trennung erfolgen.

Der Ausgangsanschluss des Symmetrierübertragers, der mit Masse verbunden ist, kann besonders niederinduktiv mit Masse verbunden sein. Auch dadurch kann das Verhalten des Symmetrierübertragers verbessert werden.

Die Verbindung der ersten und/oder zweiten Kapazität kann besonders niederinduktiv mit Masse verbunden sein. Auch dadurch kann das Verhalten des Symmetrierübertragers verbessert werden.

Die Verbindung der ersten und/oder zweiten Kapazität zu den Anschlüssen des Symmetrierübertragers kann besonders kurz und insbesondere niederinduktiv mit Masse verbunden sein. Auch dadurch kann das Verhalten des Symmetrierübertragers verbessert werden.

Eine besonders niederinduktive Verbindung kann durch eine oder mehrere der folgenden Maßnehmen erzielt werden:
- besonders breite Leiterbahnen (breiter als 5 mm)
- eine Vielzahl von Durchkontaktierungen (mehr als zwei), die in einer Reihe oder in einer Fläche angeordnet sind
- besonders kurze Verbindung, insbesondere kann das Verhältnis von Länge zu Breite der Verbindung kleiner 100, insbesondere kleiner 10, bevorzugt kleiner 3 sein.

Die erste Kapazität und die zweite Kapazität können sich in Abhängigkeit von einer parasitären Kapazität des Symmetrierübertragers zwischen den Eingangsanschlüssen und den Ausgangsanschlüssen des Symmetrierübertragers und/oder zur Masse unterscheiden. Die parasitären Kapazitäten des Symmetrierübertragers können zunächst bestimmt werden und dann für die Auslegung der ersten und zweiten Kapazität berücksichtigt werden.

Der Unterschied zwischen der ersten Kapazität und der zweiten Kapazität weist einen proportionalen Anteil zu dem Produkt aus einer parasitären Kapazität des Symmetrierübertragers, insbesondere zwischen einem Eingangsanschluss und einem Ausgangsanschluss des Symmetrierübertragers und/oder zur Masse, und dem Übertragungsverhältnis des Symmetrierübertragers auf.

Beispielsweise kann die erste Kapazität einen Kapazitätswert C0 haben und die zweite Kapazität kann einen Kapazitätswert C0 ± parasitäre Kapazität x Übertragungsverhältnis aufweisen.

Die erste und/oder zweite Kapazität kann einen diskreten Kondensator umfassen. Insbesondere kann die erste und/oder zweite Kapazität als diskreter Kondensator ausgeführt sein.

Alternativ oder zusätzlich ist es denkbar, dass die erste und/oder die zweite Kapazität zumindest teilweise als Leiterbahn, die von einer anderen Leiterbahn oder Fläche, insbesondere Massefläche, beabstandet ist, ausgebildet sind, wobei die Leiterbahn insbesondere Teil der Primärwicklung sein kann. In diesem Fall kann unter Umständen auf diskrete Kondensatoren verzichtet werden. Unterschiedliche erste und zweite Kapazitäten können beispielsweise dadurch realisiert werden, dass sich die Breite der der ersten Kapazität zugeordneten Leiterbahn und die Breite der der zweiten Kapazität zugeordneten Leiterbahn zumindest abschnittsweise unterscheiden. Auch ist denkbar die erste und/oder zweite Kapazität dadurch zu realisieren, dass die der Primärwicklung des Symmetrierübertragers zugeordnete Leiterbahn abschnittsweise mit unterschiedlichen Breiten ausgeführt wird.

Alternativ oder zusätzlich ist es denkbar, dass die der ersten Kapazität zugeordneten Leiterbahn einen anderen Abstand zu einer Masseplatte aufweist, als die der zweiten Kapazität zugeordneten Leiterbahn. Auch auf diese Weise können unterschiedliche Kapazitätswerte für die erste und zweite Kapazität realisiert werden. Auch über den Abstand zwischen Primärwicklung und Sekundärwicklung des Symmetrierübertragers können die erste und zweite Kapazität eingestellt werden.

Der Symmetrierübertrager kann auf einer Leiterkarte in Planartechnologie realisiert sein. In diesem Fall bietet es sich an, die Kapazitäten mit Hilfe von Leiterbahnen auszubilden.

Das Verstärkerteil kann zwei Transistoren aufweisen, wobei jeweils ein Transistor mit einem Ausgangsanschluss des Verstärkerteils verbunden sein kann. Durch die Verwendung von unterschiedlichen Kapazitäten an den Eingängen des Symmetrierübertragers können somit die Impedanzen der speisenden Transistoren des Verstärkerteils angepasst werden. Die Transistoren können insbesondere LDMOS Transistoren sein. Die Transistoren können als baugleiche, insbesondere als identische Transistoren ausgebildet sein. Die Transistoren können an ihren Steueranschlüssen an einen Signalübertrager angeschlossen sein.

Das Verstärkerteil kann als Push-Pull Verstärker, insbesondere in einer der Betriebsarten Class F oder Class F⁻¹ ausgestaltet sein.

Das Verstärkerteil kann als Push-Pull Verstärker, insbesondere in einer der Betriebsarten Class A, Class B, Class AB oder Class C ausgestaltet sein.

In den Rahmen der Erfindung fällt außerdem ein Verfahren zur Auslegung einer Hochfrequenzverstärkeranordnung mit einem an ein Verstärkerteil angeschlossenen Symmetrierübertrager, der einen Eingang mit zwei Eingangsanschlüssen und einen Ausgang mit zwei Ausgangsanschlüssen aufweist, mit den Verfahrensschritten gemäß Patentanspruch 13.

Somit können die Kapazitäten an den Eingängen des Symmetrierübertragers in Abhängigkeit von erfassten parasitären Kapazitäten des Symmetrierübertragers eingestellt werden. Durch diese Maßnahme kann die Gleichtaktunterdrückung des Symmetrierübertragers und damit auch die harmonische Reinheit des Ausgangssignals verbessert werden. Außerdem können unerwünschte Effekte wie Oszillation und ungleiche Erwärmung von aktiven Bauteilen reduziert oder verhindert werden.

Es kann eine parasitäre Kapazität des Symmetrierübertragers bestimmt werden, insbesondere eine parasitäre Kapazität zwischen einem Eingangsanschluss und einem Ausgangsanschluss und/oder Masse. Der Unterschied der Kapazitätswerte der ersten und zweiten Kapazität kann unter Berücksichtigung der parasitären Kapazität festgelegt oder gewählt werden.

Der Kapazitätswert der zweiten Kapazität kann unter Berücksichtigung des Übertragungsverhältnisses des Symmetrierübertragers festgelegt oder gewählt werden. Die zweite Kapazität kann so festgelegt werden, dass sie sich um das Produkt aus Übertragungsverhältnis und parasitärer Kapazität des Symmetrierübertragers oder einer dazu proportionalen Größe von der ersten Kapazität unterscheidet. Insbesondere kann die zweite Kapazität um den Betrag des Produkts aus Übertragungsverhältnis und parasitärer Kapazität größer oder kleiner sein als die erste Kapazität.

Es kann in Abhängigkeit davon, ob der Windungssinn der Windungen der Primärwicklung und der Sekundärwicklung des Symmetrierübertragers gleichsinnig oder gegensinnig ist, festgelegt oder gewählt werden, ob die zweite Kapazität größer oder kleiner ist als die erste Kapazität. Insbesondere kann der Betrag des Produkts aus Übertragungsverhältnis und parasitärer Kapazität des Symmetrierübertragers in Abhängigkeit davon, ob der Windungssinn der Windungen gleichsinnig oder gegensinnig ist, zum Kapazitätswert der ersten Kapazität addiert oder von diesem subtrahiert werden, um zum Kapazitätswert der zweiten Kapazität zu gelangen.

Die Erfindung betrifft weiterhin ein Verfahren zum Betreiben einer Hochfrequenzverstärkeranordnung mit den Merkmalen des Patentanspruch 14.

Insbesondere kann die Hochfrequenzverstärkeranordnung in einem Frequenzbereich > 3 MHz, vorzugsweise > 20 MHz besonders bevorzugt ≥ 40 MHz betrieben werden. Alternativ oder zusätzlich kann die Hochfrequenzverstärkeranordnung in einem Frequenzbereich ≤80 MHz, insbesondere ≤ 60 MHz betrieben werden.

Im Betrieb kann die Frequenz, bei der die Hochfrequenzverstärkeranordnung betrieben wird, verändert werden. Insbesondere kann die Frequenz in einem Bereich von +- 20% einer Mittenfrequenz verändert werden. Dadurch werden die Impedanzen, die an den speisenden schaltenden Elementen sichtbar sind, angenähert. Im Idealfall werden sie identisch.

Weitere Merkmale und Vorteile der Erfindung ergeben sich aus der nachfolgenden Beschreibung von Ausführungsbeispielen der Erfindung, anhand der Figuren der Zeichnung, die erfindungswesentliche Einzelheiten zeigt, sowie aus den Ansprüchen. Die dort gezeigten Merkmale sind nicht notwendig maßstäblich zu verstehen und derart dargestellt, dass die erfindungsgemäßen Besonderheiten deutlich sichtbar gemacht werden können. Die verschiedenen Merkmale können je einzeln für sich oder zu mehreren in beliebigen Kombinationen bei Varianten der Erfindung verwirklicht sein.

In der schematischen Zeichnung sind Ausführungsbeispiele der Erfindung dargestellt und in nachfolgenden Beschreibung näher erläutert.

Es zeigen:
- Fig. 1: eine schematische Darstellung einer Hochfrequenzverstärkeranordnung;
- Fig. 2: eine schematische Explosionsdarstellung eines Symmetrierübertragers, der in Planartechnik aufgebaut ist;
- Fig. 3a: ein Diagramm zur Darstellung des Phasenverlaufs bei einem Symmetrierübertrager, der symmetrische Kapazitäten an seinen Eingangsanschlüssen aufweist;
- Fig. 3b: einen Phasenverlauf für einen Symmetrierübertrager, der mit ungleichen Kapazitäten an seinen Eingangsanschlüssen betrieben wird;
- Fig. 4: ein Flussdiagramm zur Erläuterung des erfindungsgemäßen Verfahrens.

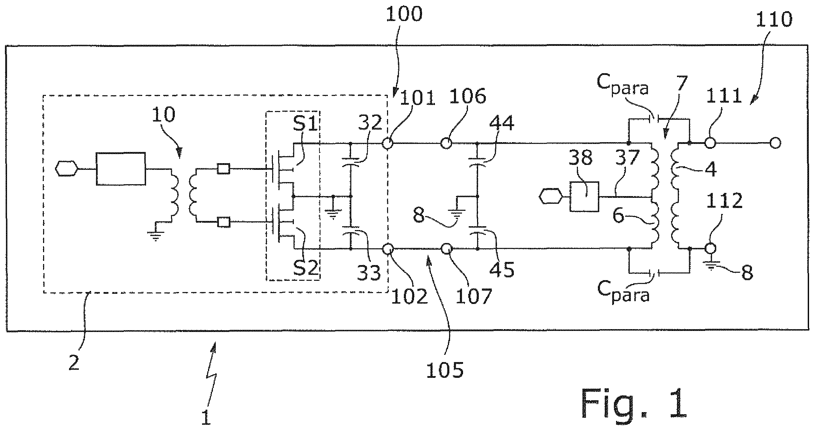

Die Figur 1 zeigt eine Hochfrequenzverstärkeranordnung 1 mit einem Verstärkerteil 2, das einen Ausgang 100 mit zwei Ausgangsanschlüssen 101, 102 aufweist. An die Ausgangsanschlüsse 101, 102 sind die Eingangsanschlüsse 106, 107 eines Eingangs 105 eines Symmetrierübertragers 7 angeschlossen. Der Symmetriebübertrager 7 weist weiterhin einen Ausgang 110 mit Ausgangsanschlüssen 111, 112 auf. Der Ausgangsanschluss 112 ist an Masse 8 angeschlossen. An den Ausgangsanschluss 111 kann eine hier nicht gezeigte Last, insbesondere eine Plasmalast, angeschlossen werden.

Die Primärwicklung 6 des Leistungsübertragers 7 weist eine Mittelpunktanzapfung 37 auf, die zur DC-Versorgung von schaltenden Elementen S1, S2 dient. An die Mittelpunktanzapfung 37 ist ein Netzwerk 38 angeschlossen, das eine Induktivität und/oder einen Kondensator aufweisen kann. Insbesondere kann eine Serienschaltung aus einem Kondensator und einer Induktivität vorgesehen sein. Alternativ könnte eine Kapazität gegen Masse und eine serielle Induktivität vorgesehen sein.

Das Verstärkerteil 2 weist schaltende Elemente S1, S2, die in diesem Fall als Transistoren, insbesondere als LDMOS Transistoren ausgebildet sind, auf. Die Sourceanschlüsse der schaltenden Elemente S1, S2 sind über jeweils einen Kondensator 32, 33 mit Masse verbunden. Angesteuert werden die schaltenden Elemente S1, S2 über einen Signalübertrager 10.

Der Symmetrierübertrager 7 ist so eingangsseitig an ein symmetrisches Leitungssystem und ausgangsseitig an ein unsymmetrisches Leitungssystem angeschlossen.

Die Eingangsanschlüsse 105, 106 des Symmetrierübertragers 7, der eine Primärwicklung 6 und eine Sekundärwicklung 4 aufweist, sind über Kapazitäten 44, 45 mit Masse 8 verbunden. Die erste Kapazität 44 ist dabei ungleich der zweiten Kapazität 45. Durch die erste und zweite Kapazität 44, 45 können die Impedanzen, die der Symmetrierübertrager 7 für die schaltenden Elemente S1, S2 darstellt, abgestimmt ("getunt") werden. Üblicherweise werden die erste und die zweite Kapazität 44, 45 symmetrisch angenommen, da beide schaltenden Elemente S1, S2 die gleiche Last sehen sollten. Erfindungsgemäß sind jedoch unterschiedliche Kapazitäten 44, 45 vorgesehen, da sich gezeigt hat, dass das Verhalten des Symmetrierübertragers 7 deutlich verbessert wird. Dies ist dadurch erklärbar, dass die Effekte, die parasitäre Kapazitäten verursachen, zumindest teilweise ausgeglichen bzw. eliminiert werden können. Die parasitären Kapazitäten treten beispielsweise zwischen den Ein- und Ausgangsanschlüssen 106, 111 und 107, 112 auf. Sie sind in der Figur 1 als Cₚₐᵣₐ markiert.

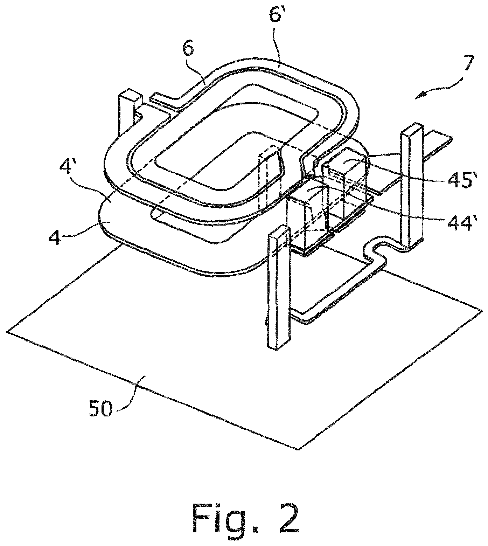

Die Kapazitäten 44, 45 können zumindest teilweise als diskrete Kondensatoren 44', 45' (Fig. 2) ausgebildet sein. Es ist jedoch auch denkbar, die erste und zweite Kapazität 44, 45 zumindest teilweise mittels Leiterbahnen auszubilden, die zu einer Massefläche beabstandet sind. Dies bietet sich insbesondere bei einem planaren Aufbau des Symmetrierübertragers 7 an. Ein solcher Aufbau ist in der Figur 2 stark schematisiert dargestellt. Hier ist zu erkennen, dass die Leiterbahn 4' der Sekundärwicklung 4 des Symmetrierübertragers 7 nicht nur eine andere Windungszahl als die Primärwicklung 6 aufweist, sondern dass die Leiterbahn 6' der Sekundärwicklung 6 zumindest in einem Bereich eine geringere Breite aufweist, als in anderen Bereichen. Durch diese Maßnahme können die Kapazitäten 44, 45 eingestellt werden.

Die Kapazitäten 44, 45 sind somit zumindest teilweise durch die Leiterbahnen 6', 4', durch die die Primärwicklung 6 und die Sekundärwicklung 4 aufgebaut sind, realisiert. Insbesondere kann sich der Kapazitätswert der ersten und zweiten Kapazität 44, 45 durch die Breite der Leiterbahnen und durch den Abstand der Leiterbahnen zu einer Masseplatte 50 ergeben. Durch eine geeignete Wahl des Platinenisoliermaterials, insbesondere durch die Dielektrizitätskonstante des Materials, kann die Kapazität ebenfalls beeinflusst werden. Die Kapazitäten 44, 45 sind in unmittelbarer Nähe der Sekundärwicklung 4 und Primärwicklung 6 angeordnet. Das bedeutet, dass die Seitenlänge bzw. der Durchmesser der flächigen Ausdehnung der Sekundärwicklung 4 und Primärwicklung 6 größer ist als der Abstand von den Anschlüssen 111, 112, 106, 107 der Sekundärwicklung 4 und Primärwicklung 6 zu den Kondensatoren 44', 45'.

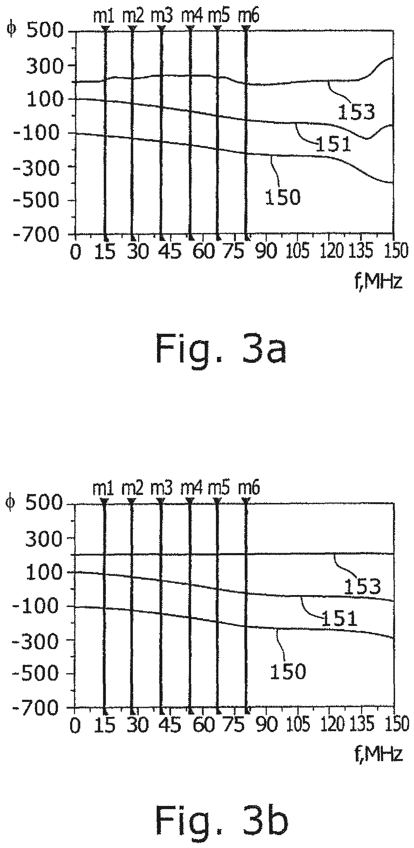

Die Figur 3a zeigt ein Diagramm, in dem der Phasenverlauf 150 zwischen dem Ausgangsanschluss 111 und Eingangsanschluss 106 und der Phasenverlauf 151 zwischen dem Ausgangsanschluss 111 und dem Eingangsanschluss 107 sowie die Phasendifferenz 153 dargestellt sind. Die Phasenverläufe sind über die Frequenz f dargestellt. In dem gezeigten Beispiel wurden symmetrische erste und zweite Kapazitäten, d.h. erste und zweite Kapazitäten, die den gleichen Kapazitätswert aufweisen, eingesetzt. Bei Messungen an den Stellen m1 bis m6 stellt man bei m1 eine Phasendifferenz von 207°, bei m2 eine Phasendifferenz von 201°, bei m3 eine Phasendifferenz von 197°, bei m4 eine Phasendifferenz von 194°, bei m5 eine Phasendifferenz von 192° und bei m6 eine Phasendifferenz von 191° fest. Diese Werte liegen von dem idealen Wert von 180° Grad entfernt.

Die Figur 3b zeigt die Phasenverläufe 150, 151 und die Phasendifferenz von 153 für den Fall, dass an den Eingängen 106, 107 Kapazitäten 44, 45 mit unterschiedlichen Kapazitätswerten eingesetzt wurden. Bei m1 stellt man daher eine Phasendifferenz von 180°, bei m2 von 181°, bei m3 von 181°, bei m4 von 182°, bei m5 von 182° und bei m6 von 183° fest. Diese Werte liegen sehr viel näher an der idealen Phasendifferenz von 180°. Die Effekte von den parasitären Kapazitäten Cₚₐᵣₐ wurden somit weitestgehend kompensiert.

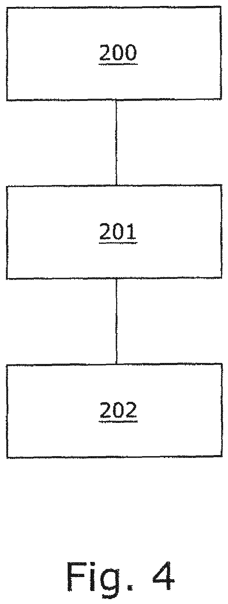

Die Figur 4 zeigt ein Flussdiagramm zur Erläuterung des erfindungsgemäßen Verfahrens. In einem ersten Schritt 200 wird eine parasitäre Kapazität eines Symmetrierübertragers 7 bestimmt, insbesondere die parasitäre Kapazität zwischen einem Eingangsanschluss und einem Ausgangsanschluss und/oder zwischen einem Eingangsanschluss und Masse oder einem Ausgangsanschluss und Masse.

Im Schritt 201 wird ein Kapazitätswert für eine erste Kapazität zwischen einem Eingangsanschluss des Symmetrierübertragers und Masse festgelegt.

Im Schritt 202 wird ein zweiter Kapazitätswert für eine zweite Kapazität zwischen einem anderen Eingangsanschluss des Symmetrierübertragers und Masse festgelegt, der sich von dem ersten Kapazitätswert unterscheidet, unter Berücksichtigung der parasitären Kapazität.

Der Schritt 202 kann umfassen, dass der Kapazitätswert der zweiten Kapazität unter Berücksichtigung des Übertragungsverhältnisses des Symmetrierübertragers festgelegt wird. Beispielsweise kann die erste Kapazität als C0 festgelegt werden, wobei C0 durch die Impedanzanforderungen des Verstärkerteils beeinflusst werden kann. Die zweite Kapazität kann dann festgelegt werden als C0 + Coffset, wobei Coffset = Übertragungsverhältnis x parasitäre Kapazität sein kann. Ist der Windungssinn der Primär- und der Sekundärwicklung des Symmetrierübertragers gegenläufig, so kann sich das Vorzeichen von Coffset umdrehen. In diesem Fall beträgt die zweite Kapazität C0 - Coffset. Alternativ können die erste und die zweite Kapazität an dem jeweils anderen Eingangsanschluss des Symmetrierübertragers positioniert werden.

Die Figur 4 zeigt ein Flussdiagramm zur Erläuterung des erfindungsgemäßen Verfahrens. In einem ersten Schritt 200 wird eine parasitäre Kapazität eines Symmetrieübertragers 7 bestimmt, insbesondere die parasitäre Kapazität zwischen einem Eingangsanschluss und einem Ausgangsanschluss und/oder zwischen einem Eingangsanschluss und Masse oder einem Ausgangsanschluss und Masse.

Im Schritt 201 wird ein Kapazitätswert für eine erste Kapazität zwischen einem Eingangsanschluss des Symmetrieübertragers und Masse festgelegt.

Im Schritt 202 wird ein zweiter Kapazitätswert für eine zweite Kapazität zwischen einem anderen Eingangsanschluss des Symmetrieübertragers und Masse festgelegt, der sich von dem ersten Kapazitätswert unterscheidet, unter Berücksichtigung der parasitären Kapazität.

Der Schritt 202 kann umfassen, dass der Kapazitätswert der zweiten Kapazität unter Berücksichtigung des Übertragungsverhältnisses des Symmetrieübertragers festgelegt wird. Beispielsweise kann die erste Kapazität als C0 festgelegt werden, wobei C0 durch die Impedanzanforderungen des Verstärkerteils beeinflusst werden kann. Die zweite Kapazität kann dann festgelegt werden als C0 + Coffset, wobei Coffset = Übertragungsverhältnis x parasitäre Kapazität sein kann. Ist der Windungssinn der Primär- und der Sekundärwicklung des Symmetrieübertragers gegenläufig, so kann sich das Vorzeichen von Coffset umdrehen. In diesem Fall beträgt die zweite Kapazität C0 - Coffset. Alternativ können die erste und die zweite Kapazität an dem jeweils anderen Eingangsanschluss des Symmetrieübertragers positioniert werden.

## Patentansprüche

1. Hochfrequenzverstärkeranordnung (1) mit einem
a. Verstärkerteil (2), das einen Ausgang (100) mit zwei Ausgangsanschlüssen (101, 102) aufweist
b. einem Symmetrierübertrager (7), der einen Eingang (105) mit zwei Eingangsanschlüssen (106, 107) und einen Ausgang (110) mit zwei Ausgangsanschlüssen (111, 112) aufweist, wobei
i. jeweils ein Ausgangsanschluss (101, 102) des Verstärkerteils (2) mit einem Eingangsanschluss (106, 107) des Symmetrierübertragers (7) verbunden ist,
ii. ein Ausgangsanschluss (112) des Symmetrierübertragers (7) mit Masse verbunden ist,
iii. ein Ausgangsanschluss (111) des Symmetrierübertragers (7) mit einer Last verbindbar ist,
iv. zwischen dem einen Eingangsanschluss (106) des Symmetrierübertragers (7) und Masse eine erste Kapazität (44) vorgesehen ist,
v. zwischen dem zweiten Eingangsanschluss (107) des Symmetrierübertragers (7) und Masse (8) eine zweite Kapazität (45) vorgesehen ist, wobei die erste Kapazität (44) ungleich der zweiten Kapazität (45) ist,
**dadurch gekennzeichnet, dass**
der Unterschied zwischen der ersten Kapazität (44) und zweiten Kapazität (45) einen proportionalen Anteil zu dem Produkt aus einer parasitären Kapazität des Symmetrierübertragers (7) zwischen einem der Eingangsanschlüsse (106, 107) und einem der Ausgangsanschlüsse (111, 112) des Symmetrierübertragers (7) und/oder zur Masse (8), und dem Übertragungsverhältnis des Symmetrierübertragers (7) aufweist.

2. Hochfrequenzverstärkeranordnung nach einem der vorhergehenden Ansprüche, **dadurch gekennzeichnet, dass** der Symmetrierübertrager (7) eine Primärwicklung (6) aufweist, die mit den zwei Eingangsanschlüssen (106, 107) verbunden ist, und eine Sekundärwicklung (4) aufweist, die mit den zwei Ausgangsanschlüssen (111, 112) verbunden ist.

3. Hochfrequenzverstärkeranordnung nach einem der vorhergehenden Ansprüche, **dadurch gekennzeichnet, dass** der Ausgangsanschluss (112) des Symmetrierübertragers (7), der mit Masse (8) verbunden ist, besonders niederinduktiv mit Masse (8) verbunden ist.

4. Hochfrequenzverstärkeranordnung nach einem der vorhergehenden Ansprüche, **dadurch gekennzeichnet, dass** die erste und/oder die zweite Kapazität (44, 45) zumindest teilweise als Leiterbahn, die von einer anderen Leiterbahn oder Fläche, insbesondere Massefläche, beabstandet ist, ausgebildet sind, wobei die Leiterbahn insbesondere Teil der Primärwicklung (8) sein kann.

5. Hochfrequenzverstärkeranordnung nach Anspruch 4, **dadurch gekennzeichnet, dass** sich die Breite der der ersten Kapazität (44) zugeordneten Leiterbahn und die Breite der der zweiten Kapazität (45) zugeordneten Leiterbahn unterscheiden.

6. Hochfrequenzverstärkeranordnung nach Anspruch 4 oder 5, **dadurch gekennzeichnet, dass** die der ersten Kapazität (44) zugeordnete Leiterbahn einen anderen Abstand zu einer Masseplatte (50) aufweist als die der zweiten Kapazität zugeordnete Leiterbahn.

7. Hochfrequenzverstärkeranordnung nach einem der vorhergehenden Ansprüche, **dadurch gekennzeichnet, dass** der Symmetrierübertrager (7) auf einer Leiterkarte in Planartechnologie realisiert ist.

8. Hochfrequenzverstärkeranordnung nach einem der vorhergehenden Ansprüche, **dadurch gekennzeichnet, dass** das Verstärkerteil (2) zwei Transistoren (S1, S2) aufweist, wobei jeweils ein Transistor (S1, S2) mit einem Ausgangsanschluss (101, 102) des Verstärkerteils (2) verbunden ist.

9. Hochfrequenzverstärkeranordnung nach einem der vorhergehenden Ansprüche, **dadurch gekennzeichnet, dass** das Verstärkerteil (2) als Push-Pull Verstärker, insbesondere in einer der folgenden Betriebsarten Class F oder Class F⁻¹ ausgestaltet ist.

10. Verfahren zur Auslegung einer Hochfrequenzverstärkeranordnung (1) mit einem an ein Verstärkerteil (2) angeschlossenen Symmetrierübertrager (7), der einen Eingang (105), mit zwei Eingangsanschlüssen (106, 107) und einen Ausgang (110) ,mit zwei Ausgangsanschlüssen (111, 112) aufweist, mit den Verfahrensschritten:
a. Bestimmen einer parasitären Kapazität des Symmetrierübertragers (7) zwischen einem der Eingangsanschlüsse (106, 107) und einem der Ausgangsanschlüsse (111, 112) des Symmetrierübertragers (7) und/oder zur Masse (8),
b. Festlegen eines ersten Kapazitätswerts für eine erste Kapazität (44) zwischen einem Eingangsanschluss (106) des Symmetrierübertragers (7) und Masse (8),
c. Festlegen eines zweiten Kapazitätswerts für eine zweite Kapazität (45) zwischen dem anderen Eingangsanschluss (107) des Symmetrierübertragers (7) und Masse (8), der sich von dem ersten Kapazitätswert unterscheidet,
**dadurch gekennzeichnet, dass**
der Unterschied zwischen der ersten Kapazität (44) und zweiten Kapazität (45) einen proportionalen Anteil zu dem Produkt aus der parasitären Kapazität des Symmetrierübertragers (7), und dem Übertragungsverhältnis des Symmetrierübertragers (7) aufweist.

## Claims

1. High-frequency amplifier arrangement (1) comprising
a. an amplifier part (2) having an output (100) with two output connections (101, 102),
b. a balun (7) having an input (105) with two input connections (106, 107) and an output (110) with two output connections (111, 112),
i. one output connection (101, 102) of the amplifier part (2) being connected to one input connection (106, 107) of the balun (7) in each case,
ii. one output connection (112) of the balun (7) being connected to ground,
iii. one output connection (111) of the balun (7) being connectable to a load,
iv. a first capacitance (44) being provided between one input connection (106) of the balun (7) and ground,
v. a second capacitance (45) being provided between the second input connection (107) of the balun (7) and ground (8), the first capacitance (44) being unequal to the second capacitance (45),
**characterized in that** the difference between the first capacitance (44) and the second capacitance (45) has a proportion proportional to the product of a parasitic capacitance of the balun (7) between one of the input connections (106, 107) and one of the output connections (111, 112) of the balun (7) and/or to ground (8), and the transmission ratio of the balun (7).

2. High-frequency amplifier arrangement according to one of the preceding claims, **characterized in that** the balun (7) has a primary winding (6) which is connected to the two input connections (106, 107) and has a secondary winding (4) which is connected to the two output connections (111, 112).

3. High-frequency amplifier arrangement according to either of the preceding claims, **characterized in that** the output connection (112) of the balun (7) which is connected to ground (8) is connected to ground (8) with particularly low inductance.

4. High-frequency amplifier arrangement according to any of the preceding claims, **characterized in that** the first and/or the second capacitance (44, 45) are designed at least in part in the form of a conductor track which is spaced apart from another conductor track or area, in particular a ground area, it being possible for the conductor track to be in particular part of the primary winding (8).

5. High-frequency amplifier arrangement according to claim 4, **characterized in that** the width of the conductor track assigned to the first capacitance (44) and the width of the conductor track assigned to the second capacitance (45) differ.

6. High-frequency amplifier arrangement according to either claim 4 or claim 5, **characterized in that** the conductor track assigned to the first capacitance (44) has a different distance from a ground plate (50) than the conductor track assigned to the second capacitance.

7. High-frequency amplifier arrangement according to any of the preceding claims, **characterized in that** the balun (7) is implemented on a printed circuit board using planar technology.

8. High-frequency amplifier arrangement according to any of the preceding claims, **characterized in that** the amplifier part (2) has two transistors (S1, S2), one transistor (S1, S2) being connected to one output connection (101, 102) of the amplifier part (2) in each case.

9. High-frequency amplifier arrangement according to any of the preceding claims, **characterized in that** the amplifier part (2) is designed as a push-pull amplifier, in particular in one of the following Class F or Class F⁻¹ operating modes.

10. Method for designing a high-frequency amplifier arrangement (1) comprising a balun (7) which is connected to an amplifier part (2) and has an input (105) with two input connections (106, 107) and an output (110) with two output connections (111, 112), comprising the method steps of:
a. determining a parasitic capacitance of the balun (7) between one of the input connections (106, 107) and one of the output connections (111, 112) of the balun (7) and/or to ground (8),
b. defining a first capacitance value for a first capacitance (44) between an input connection (106) of the balun (7) and ground (8),
c. defining a second capacitance value for a second capacitance (45) between the other input connection (107) of the balun (7) and ground (8), which differs from the first capacitance value,
**characterized in that** the difference between the first capacitance (44) and the second capacitance (45) has a proportion proportional to the product of the parasitic capacitance of the balun (7) and the transmission ratio of the balun (7).

## Revendications

1. Ensemble amplificateur à haute fréquence (1) comprenant
a. une partie amplificateur (2) qui comporte une sortie (100) pourvue de deux bornes de sortie (101, 102),
b. un transformateur-symétriseur (7) qui comporte une entrée (105) pourvue de deux bornes d'entrée (106, 107) et une sortie (110) pourvue de deux bornes de sortie (111, 112),
i. une borne de sortie (101, 102) de la partie amplificateur (2) étant respectivement reliée à une borne d'entrée (106, 107) du transformateur-symétriseur (7),
ii. une borne de sortie (112) du transformateur-symétriseur (7) étant reliée à la masse,
iii. une borne de sortie (111) du transformateur-symétriseur (7) pouvant être reliée à une charge,
IV. une première capacité (44) étant prévue entre la première borne d'entrée (106) du transformateur-symétriseur (7) et la masse,
v. une deuxième capacité (45) étant prévue entre la deuxième borne d'entrée (107) du transformateur-symétriseur (7) et la masse (8), la première capacité (44) étant différente de la deuxième capacité (45),
**caractérisé en ce que**
la différence entre la première capacité (44) et la deuxième capacité (45) présente une proportion proportionnelle au produit d'une capacité parasite du transformateur-symétriseur (7), entre l'une des bornes d'entrée (106, 107) et l'une des bornes de sortie (111, 112) du transformateur-symétriseur (7) et/ou par rapport à la masse (8), et du rapport de transmission du transformateur-symétriseur (7).

2. Ensemble amplificateur à haute fréquence selon l'une des revendications précédentes, **caractérisé en ce que** le transformateur-symétriseur (7) comporte un enroulement primaire (6) qui est relié aux deux bornes d'entrée (106, 107) et un enroulement secondaire (4) qui est relié aux deux bornes de sortie (111, 112).

3. Ensemble amplificateur à haute fréquence selon l'une des revendications précédentes, **caractérisé en ce que** la borne de sortie (112) du transformateur-symétriseur (7), qui est reliée à la masse (8), est notamment reliée à la masse (8) de manière faiblement inductive.

4. Ensemble amplificateur à haute fréquence selon l'une des revendications précédentes, **caractérisé en ce que** la première et/ou la deuxième capacité (44, 45) sont conçues au moins partiellement comme une piste conductrice qui est espacée d'une autre piste conductrice ou surface, notamment une surface de masse, la piste conductrice pouvant notamment faire partie de l'enroulement primaire (8) .

5. Ensemble amplificateur à haute fréquence selon la revendication 4, **caractérisé en ce que** la largeur de la piste conductrice associée à la première capacité (44) et la largeur de la piste conductrice associée à la deuxième capacité (45) sont différentes.

6. Ensemble amplificateur à haute fréquence selon la revendication 4 ou 5, **caractérisé en ce que** la piste conductrice associée à la première capacité (44) est à une autre distance d'une plaque de masse (50) que la piste conductrice associée à la deuxième capacité.

7. Ensemble amplificateur à haute fréquence selon l'une des revendications précédentes, **caractérisé en ce que** le transformateur-symétriseur (7) est réalisé sur une carte de circuit imprimé par une technologie planaire.

8. Ensemble amplificateur à haute fréquence selon l'une des revendications précédentes, **caractérisé en ce que** la partie amplificateur (2) comporte deux transistors (S1, S2), un transistor (S1, S2)respectivement étant relié à une borne de sortie (101, 102) de la partie amplificateur (2) .

9. Ensemble amplificateur à haute fréquence selon l'une des revendications précédentes, **caractérisé en ce que** la partie amplificateur (2) est conçue comme un amplificateur push-pull, notamment dans l'un des types de fonctionnement suivants Class F ou Class F⁻¹.

10. Procédé de conception d'un ensemble amplificateur à haute fréquence (1) comprenant un transformateur-symétriseur (7) qui est relié à une partie amplificateur (2) et qui comporte une entrée (105) pourvue de deux bornes d'entrée (106, 107) et une sortie (110) pourvue de deux bornes de sortie (111, 112), ledit procédé comprenant les étapes suivantes :
a. déterminer une capacité parasite du transformateur-symétriseur (7) entre l'une des bornes d'entrée (106, 107) et l'une des bornes de sortie (111, 112) du transformateur-symétriseur (7) et/ou par rapport à la masse (8),
b. spécifier une première valeur de capacité pour une première capacité (44) entre une borne d'entrée (106) du transformateur-symétriseur (7) et la masse (8),
c. spécifier une deuxième valeur de capacité, différente de la première valeur de capacité, pour une deuxième capacité (45) entre l'autre borne d'entrée (107) du transformateur-symétriseur (7) et la masse (8),
**caractérisé en ce que**
la différence entre la première capacité (44) et la deuxième capacité (45) présente une proportion proportionnelle au produit de la capacité parasite du transformateur-symétriseur (7) et du rapport de transmission du transformateur-symétriseur (7).
